# EUROPÄISCHE PATENTSCHRIFT

(11) **EP 1 054 549 B1**
(45) Veröffentlichungstag und Bekanntmachung des Hinweises auf die Patenterteilung: **12.09.2007**
(21) Anmeldenummer: 00110407.4
(22) Anmeldetag: 16.05.2000
(51) Int. Cl.: H04M 1/02, G06F 1/16

(54) **Vorrichtung zur Aufnahme und Befestigung eines optischen Anzeigemittels für ein Telekommunikationsgerät**
Arrangement for mounting and fastening an optical display device in a telecommunication apparatus
Dispositif de montage et de fixation d'un élément d'affichage optique dans un appareil de télécommunication

(30) Priorität: 19.05.1999 DE 29909079 U
(43) Veröffentlichungstag der Anmeldung: 22.11.2000
(73) Patentinhaber: Aastra DeTeWe GmbH, 10997 Berlin (DE)
(72) Erfinder: Stender, Ingrid, 10409 Berlin (DE)
(74) Vertreter: Fischer, Uwe

(56) Entgegenhaltungen:
- EP-A- 0 310 889
- EP-A- 0 524 430
- DE-U1- 8 808 947
- DE-U1- 9 214 643
- DE-U1- 9 416 849

## Beschreibung

Die Erfindung betrifft eine Vorrichtung zur Aufnahme und Befestigung eines optischen Anzeigemittels für ein Telekommunikationsgerät gemäß dem Oberbegriff des Anspruchs 1.

Es ist bekannt, in der Oberschale bzw. der Gehäusekappe eines Telekommunikationsgerätes einen Ausschnitt zur Aufnahme eines optischen Anzeigemittels vorzusehen und mit transparenten Teilen für Leuchtanzeigen und/oder Abdeckungen für Flüssigkristallanzeigen zu versehen. Derartige Abdeckungen werden üblicherweise mit der Gehäusekappe verklebt oder verschraubt.

Da diese Fertigungsmaßnahme einer vollkommenen Wiederverwertung des Werkstoffes widerspricht, da beispielsweise das einen sicheren Staubabschluß gewährleistende Verkleben Verunreinigungen des Werkstoffes bei einer Neuaufbereitung verursacht, ist aus der DE 43 34 692 C2 eine Abdeckung und Aufnahmevorrichtung für optische Anzeigemittel bekannt, die in Gehäusekappen von Telekommunikations-Endgeräten montiert ist, bei der die Abdeckung ein erhabenes Fenster und zylinderförmige Aufnahmen mit aufgesetzten quaderförmigen Lichtaustrittsöffnungen aufweist und aus transparentem Werkstoff desselben Materials wie das der Gehäusekappe besteht. Zur Justierung und Befestigung der die optischen Anzeigemittel aufnehmenden Trägerplatte sind Zapfen und Pfosten vorgesehen und für den Durchgriff eines Steges der Gehäusekappe dient ein Schlitz zwischen Fenster und Aufnahmen.

Die europäische Patentanmeldung EP 0 310 889 beschreibt eine Anzeigeanordnung für einen Telefonhörer mit einer Halterung für ein Anzeigeelement. Das Anzeigeelement wird durch Schnapphaken, die den Rand des Anzeigeelements umfassen, gehalten.

Die europäische Patentanmeldung EP 0 524 430 sowie das Gebrauchsmuster DE-U 94 16 849 beschreiben jeweils Displayhalterungen, bei denen das Anzeigeelement zwischen einer Abdeckung und flexiblen Elementen eingeklemmt wird.

Der vorliegenden Erfindung liegt die Aufgabenstellung zugrunde, eine Vorrichtung zur Aufnahme und Befestigung eines optischen Anzeigemittels für ein Telekommunikationsgerät anzugeben, die eine elektrische Kontaktierung und Verbindung des optischen Anzeigemittels mit einer Leiterplatte sowie eine exakte Ausrichtung des optischen Anzeigemittels auf die Anzeigeöffnung der Gehäusekappe eines Telekommunikationsgerätes ohne Schraub- und Klebeverbindungen ermöglicht, sowie einfach aufgebaut und mit nur geringem Aufwand montierbar und demontierbar ist.

Diese Aufgabe wird erfindungsgemäß durch die Merkmale des Anspruchs 1 gelöst.

Die erfindungsgemäße Lösung ermöglicht eine elektrische Kontaktierung und Verbindung des optischen Anzeigemittels mit einer Leiterplatte sowie eine exakte Ausrichtung des optischen Anzeigemittels auf eine Anzeigeöffnung in der Gehäusekappe eines Telekommunikationsgerätes, ohne daß hierfür Schraub- oder Klebeverbindungen erforderlich sind. Der einfache Aufbau der gesamten Vorrichtung und ihre Zusammensetzung aus einzelnen formschlüssig miteinander verbindbaren Modulen gewährleistet einen geringeren Montage- und Demontageaufwand.

Vorzugsweise besteht das optische Anzeigemittel aus einer rechteckigen, plattenförmigen Flüssigkristallanzeige, die auf der Oberfläche der Halterung durch Aufnahme- und Justierelemente befestigt und mittig ausgerichtet wird. Hierfür sind an einer Seite der Oberfläche der Halterung um eine Seitenkante der Flüssigkristallanzeige greifende Aufnahmehaken sowie an zwei weiteren, einander gegenüberliegenden Seiten und an der vierten Seite der Oberfläche der Halterung federnde Haken angeordnet, die an den zugeordneten Seitenkanten der Flüssigkristallanzeige anliegen und diese mittig justieren.

Dadurch wird die Flüssigkristallanzeige sowohl in Bezug auf die Leiterplatte als auch in Bezug auf die für die Aufnahme des optischen Anzeigemittels vorgesehene Ausnehmung in der Gehäuseschale bzw. -kappe des Telekommunikationsgerätes exakt justiert und ausgerichtet sowie fest mit dem Anzeigemodul verbunden.

Eine vorteilhafte Ausgestaltung der erfindungsgemäßen Lösung ist dadurch gekennzeichnet, daß die federnden Haken an zwei Ecken der Halterung angeordnet sind, die der mit den Aufnahmehaken versehenen Seite der Halterung gegenüberliegen, und daß jeweils ein von der Oberfläche der Halterung abstehender Führungssteg an den Seiten der Halterung angeordnet ist, die an die mit den Aufnahmehaken versehene Seite der Halterung angrenzen und die an den zugeordneten Seitenkanten der Flüssigkristallanzeige anliegen.

Durch die federnden Haken an den Eckpunkten der Halterung wird eine mittige Jusierung der Flüssigkristallanzeige sowie in Verbindung mit den seitlichen Führungsstegen eine einfache und schnelle Montage der Flüssigkristallanzeige auf der Halterung gewährleistet.

Eine Weiterbildung der erfindungsgemäßen Lösung ist dadurch gekennzeichnet, daß die Halterung eine Öffnung zur Aufnahme eines Leitgummis aufweist, der mit Anschlußkontakten der Flüssigkristallanzeige kontaktiert. Vorzugsweise ist die Öffnung zwischen den Aufnahmehaken angeordnet.

Die Öffnung in der Halterung gewährleistet ebenfalls eine einfache Montage sowie Ausrichtung des Leitgummis auf die elektrischen Leitungszüge bzw. Kontakte an der Flüssigkristall-Anzeigeplatte und der Leiterplatte, ohne daß für die Kontaktierung spezielle Justage- und Fixiermittel an der Flüssigkristallanzeige bzw. der Leiterplatte erforderlich sind.

Eine weitere vorteilhafte Ausgestaltung der erfindungsgemäßen Lösung ist dadurch gekennzeichnet, daß zwischen der Halterung und der Leiterplatte im Bereich einer Seite der Halterung eine auf einer Platte angebrachte Beleuchtungseinrichtung angeordnet ist, wobei ein Teil der Platte in einer Aussparung der Halterung fixiert ist und die Beleuchtungseinrichtung über Stifte mit auf der Leiterplatte angeordneten Buchsen elektrisch verbunden ist.

Durch diese konstruktive Maßnahme und durch die Funktion der Halterung wird ebenfalls eine einfache Montage sowie Ausrichtung einer Rückseitenbeleuchtung (Backlite) gewährleistet.

Zur Verbindung der Halterung mit der Leiterplatte sowie zur exakten Ausrichtung der Halterung auf der Leiterplatte und damit des Flüssigkristall-Anzeigemoduls in Bezug auf die Leiterplatte und die Gehäuseschale des Telekommunikationsgerätes sind an der Unterseite der Halterung Befestigungs- und Zentrierelemente vorgesehen, mit denen die Halterung kraft- und/oder formschlüssig mit der Leiterplatte verbunden ist. Die Befestigungs- und Zentrierelemente bestehen vorzugsweise aus Schnapphaken und Rippen, die an einander gegenüberliegenden Seiten der Halterung angeordnet sind und um die Seitenkanten der Leiterplatte greifen bzw. an den Seitenkanten der Leiterplatte anliegen.

Eine genaue Lageausrichtung der Halterung in Bezug auf die Leiterplatte wird dadurch erzielt, daß in den Seitenkanten der Leiterplatte einander gegenüberliegende Nuten oder Ausbrüche angeordnet sind, in die an den Innenseiten der Schnapphaken angeordnete Zentriervorsprünge rastend eingreifen.

Zum staubdichten Einfassen und zum Schutz der Flüssigkristallanzeige weist die Oberfläche der Abdeckung ein die Anzeigefläche der Flüssigkristallanzeige abdeckendes, transparentes Fenster auf. Zur Befestigung der Abdeckung an der Halterung derart, daß die Flüssigkristallanzeige zwischen Abdeckung und Halterung eingefaßt ist, weist die Abdeckung von ihrer Oberfläche rechtwinklig abstehende Seitenflächen auf, die im montierten Zustand des Flüssigkristall-Anzeigemoduls an den Seitenflächen der Halterung anliegen.

Zur formschlüssigen Lagefixierung weisen die Seitenflächen der Abdeckung im Bereich der Befestigungs- und Zentrierelemente der Halterung Ausbrüche sowie im Bereich der Aufnahmehaken der Halterung Ausnehmungen auf, die die Aufnahmehaken einfassen.

Weitere Vorteile und Einzelheiten der Erfindung sollen an einem in der Zeichnung dargestellten Ausführungsbeispiel verdeutlicht und erläutert werden. Es zeigen:
- Fig. 1 -: eine perspektivische Darstellung einer Oberschale bzw. Gehäusekappe eines schnurlosen Telefons oder Mobiltelefons;
- Fig. 2 -: eine perspektivische Darstellung einer in die Gehäusekappe gemäß Fig. 1 einsetzbaren Leiterplatte;
- Fig. 3 -: eine Explosionsdarstellung einer Vorrichtung zur Aufnahme und Befestigung eines optischen Anzeigemittels an der Leiterplatte gemäß Fig. 2 und
- Fig. 4 -: eine auf der Leiterplatte gemäß Fig. 2 befestigte Vorrichtung gemäß Fig. 3.

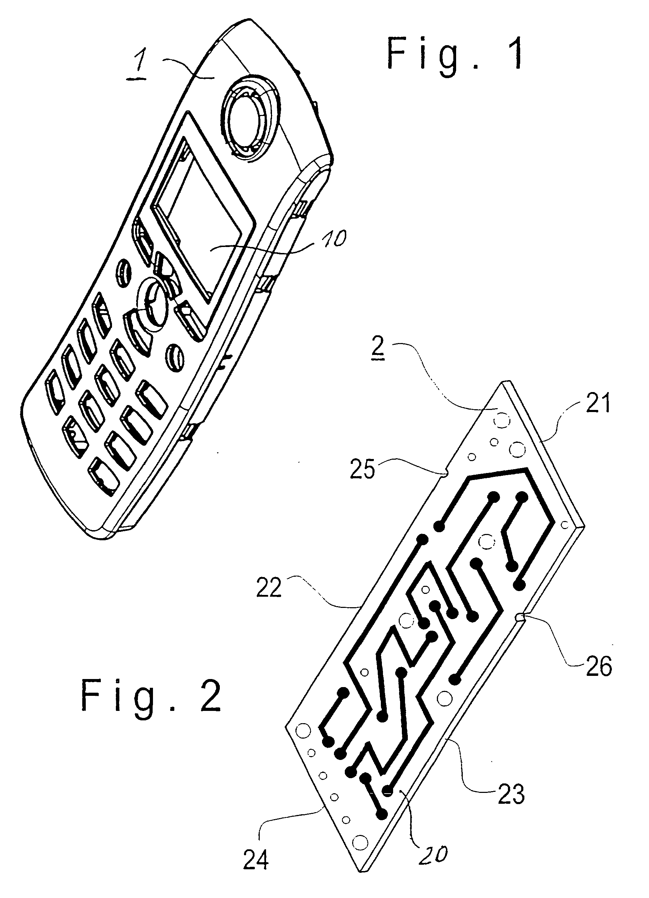

Fig. 1 zeigt in perspektivischer Ansicht eine Oberschale oder Gehäusekappe 1 eines schnurlosen Telefons oder Mobiltelefons mit einem fensterförmigen Ausschnitt 10 zur Aufnahme eines optischen Anzeigemittels in Form einer Flüssigkristallanzeige sowie mehrere weitere, nicht näher bezeichnete Öffnungen zur Aufnahme weiterer optischer Anzeigemittel und Bedienungstasten.

In die Gehäusekappe 1 oder eine nicht dargestellte, mit der Gehäusekappe 1 verbindbare Unterschale des Telekommunikationsgerätes wird eine schematisch-perspektivische in Fig. 2 dargestellte Leiterplatte 2 eingesetzt, die die elektronische Schaltung zum Betrieb des Telekommunikationsgerätes aufweist und mit den Bedienungselementen und optischen Anzeigemitteln elektrisch verbunden wird.

Die Leiterplatte 2 ist quaderförmig mit einer gegenüber ihrer Fläche geringen Dicke ausgebildet und weist eine durch senkrecht zueinander stehende Seitenkanten 21 bis 24 begrenzte Oberfläche 20 auf, auf der die Leiterzüge der elektronischen Schaltung bzw. die elektronischen Bauelemente angeordnet sind. Weiterhin sind Bohrungen zur kraft- und/oder formschlüssigen Verbindung der Leiterplatte 2 mit der Unterschale bzw. Gehäusekappe 1 des Telekommunikationsgerätes vorgesehen. An zwei einander gegenüberliegenden Seitenkanten 22, 23 der Leiterplatte 2 sind Nuten oder Ausbrüche 25, 26 vorgesehen, die in nachstehend beschriebener Weise zur Justierung und Zentrierung der Vorrichtung zur Aufnahme und Befestigung des optischen Anzeigemittels dienen.

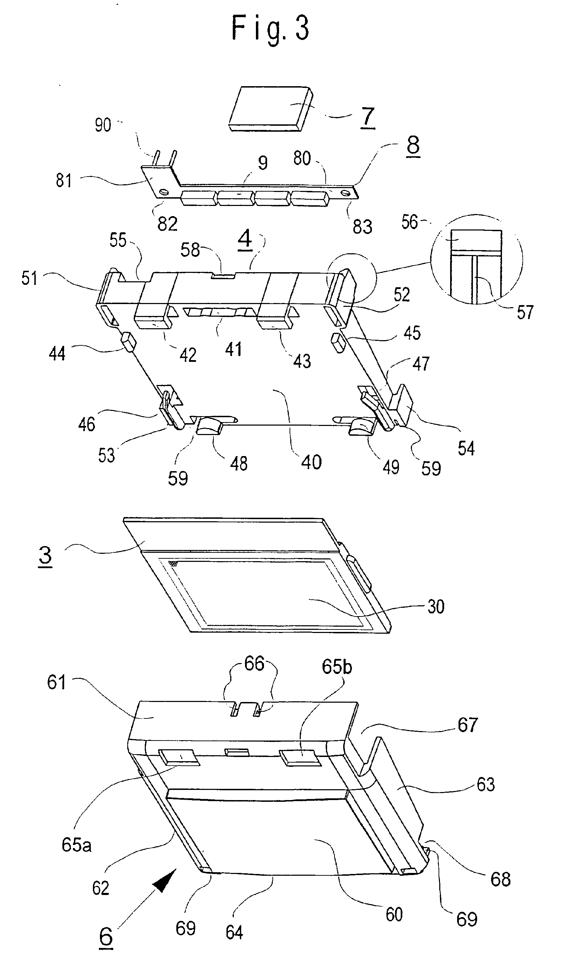

Fig. 3 zeigt in perspektivischer Explosionsdarstellung ein Flüssigkristall-Anzeigemodul, das aus der Flüssigkristallanzeige 3, einer die Flüssigkristallanzeige 3 aufnehmenden Halterung 4, einer die Flüssigkristallanzeige 3 abdeckenden und mit der Halterung 4 verbindbaren Abdeckung 6, einem Leitgummi 7 und einer Beleuchtungseinrichtung (Backlite) 8 zusammengesetzt ist.

Das zusammengesetzte Flüssigkristall-Anzeigemodul wird auf die Leiterplatte 2 aufgesetzt und mit dieser formschlüssig verbunden sowie über den Leitgummi 7 und über Steckbuchsen auf der Leiterplatte 2 und Steckerstifte 81 an der Beleuchtungseinrichtung 8 elektrisch verbunden. Dabei ist das Flüssigkristall-Anzeigemodul auf der Leiterplatte 2 so ausgerichtet, daß ein die Anzeigefläche 30 der Flüssigkristallanzeige 3 abdeckendes, transparentes Fenster 60 der Abdekkung 6 die fensterartige Ausnehmnung 10 in der Oberschale bzw. Gehäusekappe 1 des Telekommunikationsgerätes ausfüllt.

Bei einem Zusammenbau des Flüssigkristall-Anzeigemoduls gemäß Fig. 3 wird zunächst die plattenförmige Flüssigkristallanzeige 3 mit der Halterung 4 verbunden und durch diese mittig justiert. Zu diesem Zweck weist die Halterung 4 eine Oberfläche 40 und mehrere Aufnahme- und Justierelemente 42 bis 49 zur Aufnahme und Justierung der plattenförmigen Flüssigkristallanzeige 3 auf der Halterung 4 auf.

Die Aufnahme- und Justierelemente bestehen aus an der Oberkante der Halterung 4 angeordneten Aufnahmehaken 42, 43 mit U-förmigen Aufnahmeschlitzen, die um die Oberkante der Flüssigkristallanzeige 3 greifen, sowie federnde Haken 46, 48 bzw. 47, 49, die an den Eckpunkten zwischen der Unterkante und den Seitenkanten der Halterung 4 angeordnet sind.

Weiterhin sind Führungsstege 44, 45 vorgesehen, die parallel zu den Seitenkanten der Halterung 4 verlaufend auf der Oberfläche 40 der Halterung 4 angeordnet sind.

Zur Verbindung der Flüssigkristallanzeige 3 mit der Halterung 4 wird die Flüssigkristall-Anzeigeplatte mit ihrer Oberkante in die Aufnahmehaken 42, 43 eingesteckt und durch Aufdrücken der Flüssigkristallanzeige 3 auf die Oberfläche 40 der Halterung 4 werden die federnden Haken 46, 48 bzw. 47, 49 geringfügig nach außen gedrückt und liegen federnd an den Seitenkanten der Flüssigkristallanzeige 3 an und justieren diese mittig in bezug auf die Halterung 4, wobei die Führungsstege 44, 45 formschlüssig an den Seitenkanten der Flüssigkristallanzeige 3 anliegen.

Zur weiteren Montage des Flüssigkristall-Anzeigemoduls wird die Abdeckung 6 auf die Halterung 4 so aufgesetzt, daß die Flüssigkristallanzeige 3 zwischen Halterung 4 und Abdekkung 6 eingespannt ist und das transparente Fenster 60 der Abdeckung 6 über der Anzeigefläche 30 der Flüssigkristallanzeige 3 liegt und die Flüssigkristallanzeige staub- und schlaggeschützt einfaßt. Hierfür weist die Abdeckung 6 von der Oberfläche der Halterung 4 rechtwinklig abstehende Seitenflächen 61 bis 64, die um die Seitenkanten der Flüssigkristallanzeige 3 greifen und an den Seitenflächen der Halterung 4 anliegen, sowie Schnapphaken 66, 69 auf, die in entsprechende Hinterschnitte 58, 59 an der Halterung 4 kraft- und formschlüssig eingreifen.

An der Oberfläche der Halterung 4 vorgesehene Freimachungen 65a, 65b umgeben im montierten Zustand der Vorrichtung die Aufnahmehaken 42, 43 der Halterung 4 und sind der Form der Aufnahmehaken 42, 43 angepaßt.

Zur Befestigung der Abdeckung 6 auf der Halterung 4 sind auf der einen Seitenfläche 61 der Abdeckung 6 zwei Schnapphaken 66 vorgesehen, die in den Hinterschnitt 58 der Halterung 4 einrasten. Weitere Schnapphaken 69 in den Eckbereichen der der Seitenfläche 61 gegenüberliegenden Seitenfläche 64 rasten ebenfalls in Hinterschnitte 59 der Halterung 4 im Eckbereich der dem Hinterschnitt 58 gegenüberliegenden Seite der Halterung 4 ein. Weiterhin sind an der Abdeckung 6 Ausbrüche 67, 68 vorgesehen, die die nachstehend beschriebenen Befestigungs- und Zentrierelemente der Halterung 4 einfassen, mit denen die Halterung 4 auf der Leiterplatte 2 befestigt wird. Durch die Schnapphaken 66 und 69 ist die Abdeckung 6 form- und kraftschlüssig mit der Halterung 4 verbunden und gewährleistet einen sicheren Sitz auf der Halterung 4 sowie eine vollständig staubgeschützte Einbindung der Flüssigkristallanzeige 3 in dem Flüssigkristall-Anzeigemodul.

In eine im wesentlichen rechteckförmige Öffnung 41 der Halterung 4 ist ein quaderförmiger Leitgummi 7 einsetzbar und mit entsprechenden Kontakten der Flüssigkristallanzeige 3 verbindbar.

Weiterhin wird zur Rückseitenbeleuchtung des Flüssigkristall-Anzeigemoduls eine Beleuchtungseinrichtung 8 in die Halterung 4 eingesetzt und an der Halterung 4 ausgerichtet. Die Beleuchtungseinrichtung 8 besteht aus einer plattenförmigen Aufnahme 80, auf der nebeneinander mehrere Beleuchtungselemente 9 angeordnet sind. Die plattenförmige Aufnahme 80 weist eine abgewinkelte Fläche 81 auf, an der Kontaktstifte 90 angeordnet und mit entsprechenden Buchsen auf der Leiterplatte 2 verbindbar sind. Zur Justierung und Arretierung der Aufnahme 80 an der Halterung 4 weist die Aufnahme 80 an gegenüberliegenden Enden Durchbrüche 82, 83 auf, in die von der Unterseite der Halterung 4 abstehende, in Figur 3 nicht näher erkennbare Dome eingreifen und durch thermische Verformung mit den Durchbrüchen 82, 83 verbunden werden. Weiterhin weist die Halterung 4 eine Aussparung 55 auf, in die die abgewinkelte Fläche 81 der Aufnahme 80 eingesetzt wird.

Zur Befestigung des so zusammengesetzten Flüssigkristall-Anzeigemoduls an der Leiterplatte 2 sind an der Halterung 4 Befestigungs- und Zentrierelemente 51 bis 57 vorgesehen, die über den Rand der Leiterplatte 2 greifen und die Halterung 4 und damit das Flüssigkristall-Anzeigemodul an der Leiterplatte 2 fixieren und auf der Leiterplatte 2 lagerichtig ausrichten.

Zum Zentrieren und Ausrichten des Flüssigkristall-Anzeigemoduls auf der Leiterplatte 2 dienen die zuvor in verbindung mit der Figur 2 beschriebenen Nuten bzw. Ausbrüche 25, 26 an den Seitenkanten 22, 23 der Leiterplatte 2, die so angeordnet sind, daß das Flüssigkristall-Anzeigemodul in bezug auf die Oberschale bzw. Gehäusekappe 1 exakt ausgerichtet wird und die für die Flüssigkristallanzeige erforderlichen elektrischen Kontakte mit den Verbindungselementen der Leiterplatte 2 hergestellt werden.

Die Befestigungs- bzw. Zentrierelemente bestehen aus Schnapphaken 51, 52, die an den Seitenkanten der Halterung 4 angeordnet sind und an die Oberkante der Halterung 4 angrenzen. An den entgegengesetzten Eckpunkten der Seitenkanten der Halterung 4 im Bereich der Unterkante der Halterung 4 sind Rippen 53, 54 vorgesehen, die ebenfalls über die Leiterplatte 2 greifen und Führungsfunktionen zum Verhindern eines Verdrehens der Halterung 4 auf der Leiterplatte 2 ausüben.

Die Schnapphaken 51, 52 weisen gemäß der vergrößerten Einzelteildarstellung elastische hakenförmige Elemente 56, die um die Seitenkanten 22, 23 der Leiterplatte 2 schnappen und einen Zentriersteg 57 auf, der bei der Montage formschlüssig in die Nuten bzw. Ausbrüche 25, 26 an den Seitenkanten 22, 23 der Leiterplatte 2 einrastet. Dadurch wird die Lage des Flüssigkristall-Anzeigemoduls auf der Leiterplatte 2 durch die kraft- und formschlüssige Anlage der Schnapphaken 51, 52 sowie über die Nuten bzw. Ausbrüche 25, 25 an der Leiterplatte 2 fixiert.

Um ein Verdrehen des Flüssigkristall-Anzeigemoduls auf der Leiterplatte 2 zu verhindern, greifen die Rippen 53, 54 über die Seitenkanten der Leiterplatte und legen sich formschlüssig an die Seitenkanten 22, 23 der Leiterplatte 2 an.

Abweichend von der vorstehend beschriebenen Montage des Flüssigkristall-Anzeigemoduls auf der Leiterplatte 2 kann selbstverständlich auch zunächst die Halterung 4 mit oder ohne zuvor auf der Halterung 4 fixierter Flüssigkristallanzeige 3 auf der Leiterplatte 2 fixiert und anschließend die Abdeckung 6 über die Flüssigkristallanzeige 3 und die Halterung 4 gesteckt werden.

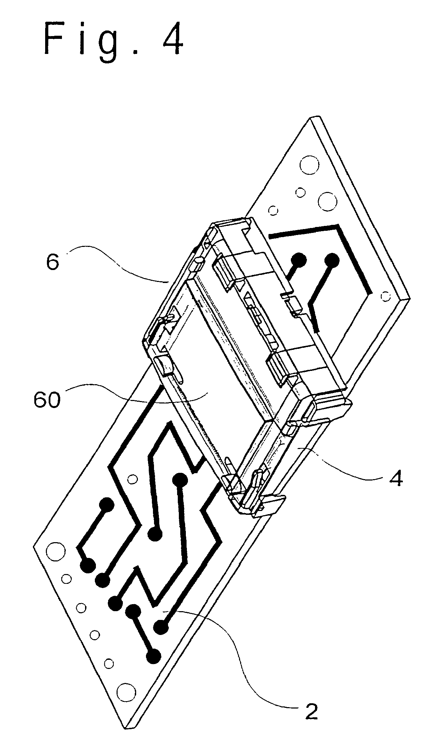

Fig. 4 zeigt das mit der Leiterplatte 2 verbundene Flüssigkristall-Anzeigemodul mit der Halterung 4 und der Abdeckung 6 sowie dem transparenten Fenster 60 der Abdeckung 6, das über der Anzeigefläche 30 der Flüssigkristallanzeige 3 liegt und die Flüssigkristallanzeige staub- und schlaggeschützt einfaßt, in perspektivischer Ansicht. Das so mit der Leiterplatte 2 verbundene Modul wird anschließend in die Gehäusekappe oder Oberschale 1 des Telekommunikationsgerätes gemäß Fig. 1 bzw. in die Unterschale des Gehäuses eingesetzt.

## Patentansprüche

1. Vorrichtung zur Aufnahme und Befestigung eines optischen Anzeigemittels(3) für ein Telekommunikationsgerät, das ein Gehäuse aufweist, in dem das optische Anzeigemittel eingesetzt und mit einer Leiterplatte des Telekommunikationsgerätes verbunden ist, wobei die Vorrichtung eine Halterung (4) aufweist und wobei an einer ersten Seite der Oberfläche (40) der Halterung (4) und an einer der ersten Seite gegenüberliegenden zweiten Seite der Oberfläche (40) der Halterung (4) Haltemittel angeordnet sind,
**dadurch gekennzeichnet**
- **dass** die Haltemittel auf der ersten Seite der Oberfläche (40) der Halterung (4) durch Aufnahmehaken (42; 43) gebildet sind, in die das Anzeigemittel zur Montage mit einer Seitenkante seitlich einzustecken ist, und
- **dass** die Haltemittel auf der zweiten Seite der Oberfläche (40) der Halterung (4) durch federnde schwenkbare Haken (48, 19) gebildet sind, die um eine Schwenkachse senkrecht zur Oberfläche (40) der Halterung (4) schwenkbar sind und beim Einsetzen des Anzeigemittels weggeschwenkt werden und nach der Montage an einer der genannten Seitenkante gegenüberliegenden weiteren Seitenkante des Anzeigemittels seitlich anliegen.

2. Vorrichtung nach Anspruch 1, **dadurch gekennzeichnet, dass** die Aufnahmehaken (42; 43) U-förmige Aufnahmeschlitze aufweisen, in die das Anzeigemittel zur Montage mit der Seitenkante seitlich einzustecken ist und die nach erfolgter Montage um die Seitenkante des Anzeigemittels greifen, wobei die Aufnahmehaken jeweils zwei zueinander rechtwinklig angeordnete Plattenabschnitte umfassen, von denen sich einer senkrecht zur Oberfläche der Halterung und der andere parallel zur Oberfläche der Halterung erstreckt.

3. Vorrichtung nach Anspruch 1 oder 2, **dadurch gekennzeichnet, dass** an zwei weiteren, einander gegenüberliegenden Seiten der Halterung (4) federnd weitere schwenkbare Haken (46, 47) angeordnet sind, die jeweils um eine Schwenkachse senkrecht zur Oberfläche (40) der Halterung (4) schwenkbar sind und nach Montage des optischen Anzeigemittels (3) an den ihnen zugeordneten Seitenkanten des optischen Anzeigemittels (3) seitlich anliegen.

4. Vorrichtung nach mindestens einem der vorangehenden Ansprüche, **dadurch gekennzeichnet, daß** jeweils ein von der Oberfläche (40) der Halterung (4) abstehender Führungssteg (4, 45) an den Seiten der Halterung (4) angeordnet ist, die an die mit den Aufnahmehaken (42, 43) versehene Seite der Halterung (4) angrenzen und die an den zugeordneten Seitenkanten des Anzeigemittels (3) anliegen.

5. Vorrichtung nach mindestens einem der vorangehenden Ansprüche, **dadurch gekennzeichnet, daß** die Halterung (4) eine Öffnung (41) zur Aufnahme eines Leitgummis (7) aufweist, der mit Anschlußkontakten des Anzeigemittels (3) kontaktiert.

6. Vorrichtung nach Anspruch 5, **dadurch gekennzeichnet, daß** die Öffnung (41) zwischen den Aufnahmehaken (42, 43) angeordnet ist.

7. Vorrichtung nach mindestens einem der vorangehenden Ansprüche, **dadurch gekennzeichnet, daß** zwischen der Halterung (4) und der Leiterplatte (2) im Bereich einer Seite der Halterung (4) eine auf einer Platte (80) angebrachte Beleuchtungseinrichtung (8) angeordnet ist, wobei ein abgewinkelter Teil (81) der Platte (80) in einer Aussparung (55) der Halterung (4) fixiert ist und die Beleuchtungseinrichtung (8) über Stifte (90) mit auf der Leiterplatte (2) angeordneten Buchsen elektrisch verbunden ist.

8. Vorrichtung nach mindestens einem der vorangehenden Ansprüche, **gekennzeichnet durch** von der Unterseite der Halterung (4) abstehende Befestigungs- und Zentrierelemente (51 bis 54), mit denen die Halterung (4) kraft- und/oder formschlüssig mit der Leiterplatte (2) verbunden ist.

9. Vorrichtung nach Anspruch 8, **dadurch gekennzeichnet, daß** die Befestigungs- und Zentrierelemente aus Schnapphaken (51, 52) und Rippen (53, 54) bestehen, die an einander gegenüberliegenden Seiten der Halterung (4) angeordnet sind und um die Seitenkanten (22, 23) der Leiterplatte (2) greifen bzw. an den Seitenkanten (22, 23) der Leiterplatte (2) anliegen.

10. Vorrichtung nach Anspruch 9, **dadurch gekennzeichnet, daß** in den Seitenkanten (2, 23) der Leiterplatte (2) einander gegenüberliegende Nuten oder Ausbrüche (25, 26) angeordnet sind, in die an den Innenseiten der Schnapphaken (51, 52) angeordnete Zentriervorsprünge (55) rastend eingreifen.

11. Vorrichtung nach mindestens einem der vorangehenden Ansprüche, **dadurch gekennzeichnet, daß** die Oberfläche der Abdeckung (6) ein die Anzeigefläche (30) des Anzeigemittels (3) abdeckendes, transparentes Fenster (60) aufweist, und daß von der Oberfläche der Abdeckung (6) rechtwinklig Seitenflächen (61 bis 64) abstehen, die an den Seitenflächen der Halterung (4) anliegen.

12. Vorrichtung nach Anspruch 11, **dadurch gekennzeichnet, daß** die Seitenflächen (61 bis 64) der Abdeckung (6) im Bereich der Befestigungs- und Zentrierelemente (51 bis 54) der Halterung (4) Ausbrüche (67, 68) aufweist.

13. Vorrichtung nach Anspruch 11 oder 12, **dadurch gekennzeichnet, daß** die Abdeckung (6) im Bereich der Aufnahmehaken (42, 43) der Halterung (4) Freimachungen (65a, 65b) aufweist, die die Aufnahmehaken (42, 43) einfassen.

14. Vorrichtung nach mindestens einem der vorangehenden Ansprüche 11 bis 13, **dadurch gekennzeichnet, daß** zumindest an einem Teil der Seitenflächen (61 bis 64) der Abdeckung (6) Schnapphaken (58, 59) vorgesehen sind, die im montierten Zustand in Hinterschnitte (58, 59) an den Kanten der Unterseite der Halterung (4) kraft- und formschlüssig einrasten.

15. Vorrichtung nach mindestens einem der vorangehenden Ansprüche, **dadurch gekennzeichnet, dass** das optische Anzeigemittel (3), die Halterung (4), die zumindest teilweise transparente Abdeckung (6) und die Beleuchtungseinrichtung (8) als Teile eines Moduls ausgebildet und modular montierbar sind.

16. Vorrichtung nach einem der vorangehenden Ansprüche, **dadurch gekennzeichnet, dass** das optische Anzeigemittel aus einer plattenförmigen Flüssigkristallanzeige (3) besteht.

17. Vorrichtung nach einem der vorangehenden Ansprüche, **dadurch gekennzeichnet, dass** die federnd schwenkbaren Haken (46 bis 49) an zwei Ecken der Halterung (4) angeordnet sind, die der mit den Aufnahmehaken (42, 43) versehenen Seite der Halterung (4) gegenüberliegen.

## Claims

1. Apparatus for receiving and fastening a visual display means (3) for a telecommunications device which has a housing in which the visual display means is inserted and connected to a printed circuit board of the telecommunications device, with the apparatus having a holder (4), and with holding means being arranged on a first side of the surface (40) of the holder (4) and on a second side, which is opposite the first side, of the surface (40) of the holder (4),
**characterized**
- **in that** the holding means on the first side of the surface (40) of the holder (4) are formed by receiving hooks (42; 43) into which the display means can be laterally plugged by means of a side edge for mounting purposes, and
- **in that** the holding means on the second side of the surface (40) of the holder (4) are formed by sprung pivotable hooks (48, 49) which can be pivoted about a pivot axis perpendicular to the surface (40) of the holder (4) and are pivoted away when the display means is inserted and bear laterally against a further side edge, opposite the said side edge, of the display means, after mounting.

2. Apparatus according to Claim 1, **characterized in that** the receiving hooks (42;43) have U-shaped receiving slots into which the display means can be laterally plugged by means of the side edge for mounting purposes and which surround the side edge of the display means after mounting is complete, with the receiving hooks each comprising two plate sections which are arranged at right angles to one another and of which one extends perpendicular to the surface of the holder and the other extends parallel to the surface of the holder.

3. Apparatus according to Claim 1 or 2, **characterized in that** further pivotable hooks (46, 47) are arranged in a sprung manner on two further mutually opposite sides of the holder (4) and can each be pivoted about a pivot axis perpendicular to the surface (40) of the holder (4) and bear laterally against the side edges of the visual display means (3) which are associated with them after mounting of the visual display means (3).

4. Apparatus according to at least one of the preceding claims, **characterized in that** a guide web (44, 45) which protrudes from the surface (40) of the holder (4) is arranged on each of the sides of the holder (4) which adjoin the side of the holder (4) which is provided with the receiving hooks (42, 43) and which bear against the associated side edges of the display means (3).

5. Apparatus according to at least one of the preceding claims, **characterized in that** the holder (4) has an opening (41) for receiving a conductive rubber (7) which makes contact with connection contacts of the display means (3).

6. Apparatus according to Claim 5, **characterized in that** the opening (41) is arranged between the receiving hooks (42, 43).

7. Apparatus according to at least one of the preceding claims, **characterized in that** an illumination device (8) which is attached to a plate (80) is arranged between the holder (4) and the printed circuit board (2) in the region of one side of the holder (4), with an angled part (81) of the plate (80) being fixed in a cutout (55) in the holder (4) and the illumination device (8) being electrically connected to female connectors, which are arranged on the printed circuit board (2), by means of pins (90).

8. Apparatus according to at least one of the preceding claims, **characterized by** fastening and centring elements (51 to 54) which protrude from the lower face of the holder (4) and by means of which the holder (4) is connected to the printed circuit board (2) in a force-fitting and/or interlocking manner.

9. Apparatus according to Claim 8, **characterized in that** the fastening and centring elements comprise snap-action hooks (51, 52) and ribs (53, 54) which are arranged on mutually opposite sides of the holder (4) and surround the side edges (22, 23) of the printed circuit board (2) and, respectively, bear against the side edges (22, 23) of the printed circuit board (2).

10. Apparatus according to Claim 9, **characterized in that** mutually opposite grooves or broken-away areas (25, 26) are arranged in the side edges (22, 23) of the printed circuit board (2), and centring projections (55) which are arranged on the inner faces of the snap-action hooks (51, 52) engage in the said grooves or broken-away areas in a latching manner.

11. Apparatus according to at least one of the preceding claims, **characterized in that** the surface of the cover (6) has a transparent window (60) which covers the display area (30) of the display means (3), and **in that** side faces (61 to 64) which bear against the side faces of the holder (4) protrude from the surface of the cover (6) at right angles.

12. Apparatus according to Claim 11, **characterized in that** the side faces (61 to 64) of the cover (6) have broken-away areas (67, 68) in the region of the fastening and centring elements (51 to 54) of the holder (4).

13. Apparatus according to Claim 11 or 12, **characterized in that** the cover (6) has free spaces (65a, 65b), which enclose the receiving hooks (42, 43), in the region of the receiving hooks (42, 43) of the holder (4).

14. Apparatus according to at least one of the preceding Claims 11 to 13, **characterized in that** snap-action hooks (66, 69), which latch into undercuts (58, 59) at the edges of the lower face of the holder (4) in a force-fitting and interlocking manner in the mounted state, are provided at least on some of the side faces (61 to 64) of the cover (6).

15. Apparatus according to at least one of the preceding claims, **characterized in that** the visual display means (3), the holder (4), the at least partially transparent cover (6) and the illumination device (8) are in the form of parts of a module and can be mounted in a modular manner.

16. Apparatus according to one of the preceding claims, **characterized in that** the visual display means comprises a plate-like liquid crystal display (3).

17. Apparatus according to one of the preceding claims, **characterized in that** the hooks (46 to 49) which can be pivoted in a sprung manner are arranged at two corners of the holder (4) which are opposite that side of the holder (4) which is provided with the receiving hooks (42, 43).

## Revendications

1. Dispositif de montage et de fixation d'un moyen d'affichage optique (3) pour un appareil de télécommunication, qui présente un boîtier dans lequel est inséré le moyen d'affichage optique et qui est connecté à une plaquette de circuits imprimés de l'appareil de télécommunication, le dispositif présentant une fixation (4) et des moyens de fixation étant disposés d'un premier côté de la surface (40) de la fixation (4) et d'un deuxième côté de la surface (40) de la fixation (4), opposé au premier côté,
**caractérisé en ce que**
- les moyens de fixation sont formés du premier côté de la surface (40) de la fixation (4) par des crochets de réception (42, 43), dans lesquels le moyen d'affichage doit être enfoncé latéralement avec une arête latérale en vue de son montage, et
- **en ce que** les moyens de fixation sont formés du deuxième côté de la surface (40) de la fixation (4) par des crochets élastiques pivotants (48, 49), qui peuvent pivoter autour d'un axe de pivotement perpendiculairement à la surface (40) de la fixation (4) et qui sont écartés par pivotement lors de l'insertion du moyen d'affichage et après le montage, s'appliquent latéralement contre une autre arête latérale du moyen d'affichage opposée à ladite arête latérale.

2. Dispositif selon la revendication 1, **caractérisé en ce que** les crochets de réception (42, 43) présentent des fentes de réception en forme de U, dans lesquelles le moyen d'affichage doit être enfoncé latéralement avec l'arête latérale en vue de son montage et qui viennent en prise après le montage autour de l'arête latérale du moyen d'affichage, les crochets de réception comprenant à chaque fois deux portions de plaques disposées à angle droit l'une par rapport à l'autre, dont l'une s'étend perpendiculairement à la surface de la fixation et l'autre s'étend parallèlement à la surface de la fixation.

3. Dispositif selon la revendication 1 ou 2, **caractérisé en ce que** sur deux autres côtés opposés de la fixation (4) sont disposés d'autres crochets élastiques pivotants (46, 47) qui peuvent pivoter à chaque fois autour d'un axe de pivotement perpendiculairement à la surface (40) de la fixation (4), et qui, après le montage du moyen d'affichage optique (3), s'appliquent latéralement contre les arêtes latérales associées du moyen d'affichage optique (3).

4. Dispositif selon au moins l'une quelconque des revendications précédentes, **caractérisé en ce qu'**à chaque fois une nervure de guidage (44, 45) saillant de la surface (40) de la fixation (4) est disposée sur les côtés de la fixation (4) qui sont adjacents au côté de la fixation (4) pourvu des crochets de réception (42, 43) et qui s'appliquent contre les arêtes latérales associées du moyen d'affichage (3).

5. Dispositif selon au moins l'une quelconque des revendications précédentes, **caractérisé en ce que** la fixation (4) présente une ouverture (41) pour recevoir un caoutchouc conducteur (7) qui vient en contact avec des contacts de raccordement du moyen d'affichage (3).

6. Dispositif selon la revendication 5, **caractérisé en ce que** l'ouverture (41) est disposée entre les crochets de réception (42, 43).

7. Dispositif selon au moins l'une quelconque des revendications précédentes, **caractérisé en ce qu'**entre la fixation (4) et la plaquette de circuits imprimés (2), dans la région d'un côté de la fixation (4), est disposé un dispositif d'éclairage (8) monté sur une plaque (80), une partie coudée (81) de la plaque (80) étant fixée dans un évidement (55) de la fixation (4) et le dispositif d'éclairage (8) étant connecté électriquement par le biais de broches (90) à des douilles disposées sur la plaquette de circuits imprimés (2).

8. Dispositif selon au moins l'une quelconque des revendications précédentes, **caractérisé par** des éléments de fixation et de centrage (51 à 54) saillant depuis le côté inférieur de la fixation (4), avec lesquels la fixation (4) est connectée par engagement par force et/ou par coopération de forme à la plaquette de circuits imprimés (2).

9. Dispositif selon la revendication 8, **caractérisé en ce que** les éléments de fixation et de centrage se composent de crochets d'encliquetage (51, 52) et de nervures (53, 54) qui sont disposés sur des côtés opposés de la fixation (4) et qui viennent en prise autour des arêtes latérales (22, 23) de la plaquette de circuits imprimés (2) ou qui s'appliquent contre les arêtes latérales (22, 23) de la plaquette de circuits imprimés (2).

10. Dispositif selon la revendication 9, **caractérisé en ce que** dans les arêtes latérales (22, 23) de la plaquette de circuits imprimés (2) sont disposées des rainures ou des encoches opposées (25, 26) dans lesquelles viennent en prise par encliquetage des saillies de centrage (55) prévues au niveau des côtés intérieurs des crochets d'encliquetage (51, 52).

11. Dispositif selon au moins l'une quelconque des revendications précédentes, **caractérisé en ce que** la surface du recouvrement (6) présente une fenêtre (60) transparente, recouvrant la surface d'affichage (30) du moyen d'affichage (3), et **en ce que** des surfaces latérales (61 à 64) font saillie à angle droit depuis la surface du recouvrement (6) et s'appliquent contre les surfaces latérales de la fixation (4).

12. Dispositif selon la revendication 11, **caractérisé en ce que** les surfaces latérales (61 à 64) du recouvrement (6) présentent des encoches (67, 68) dans la région des éléments de fixation et de centrage (51 à 54) de la fixation (4).

13. Dispositif selon la revendication 11 ou 12, **caractérisé en ce que** le recouvrement (6) présente, dans la région des crochets de réception (42, 43) de la fixation (4), des orifices (65a, 65b) qui enferment les crochets de réception (42, 43) .

14. Dispositif selon au moins l'une quelconque des revendications précédentes 11 à 13, **caractérisé en ce qu'**au moins sur une partie des surfaces latérales (61 à 64) du recouvrement (6), on prévoit des crochets d'encliquetage (66, 69) qui s'encliquètent par engagement par force et par coopération de forme dans l'état monté dans des contre-dépouilles (58, 59) sur les arêtes du côté inférieur de la fixation (4).

15. Dispositif selon au moins l'une quelconque des revendications précédentes, **caractérisé en ce que** le moyen d'affichage optique (3), la fixation (4), le recouvrement (6) au moins partiellement transparent et le dispositif d'éclairage (8) sont réalisés sous forme de pièces d'un module et peuvent être montés de manière modulaire.

16. Dispositif selon l'une quelconque des revendications précédentes, **caractérisé en ce que** le moyen d'affichage optique se compose d'un affichage à cristaux liquides en forme de plaque (3) .

17. Dispositif selon l'une quelconque des revendications précédentes, **caractérisé en ce que** les crochets pivotants élastiques (46 à 49) sont disposés sur deux coins de la fixation (4) qui sont opposés au côté de la fixation (4) pourvu des crochets de réception (42, 43).
